# EUROPEAN PATENT APPLICATION

(11) **EP 4 819 195 A1**
(43) Date of publication of application: **07.10.2026**
(21) Application number: 24897281.2
(22) Date of filing: 12.11.2024
(51) Int. Cl.: H01L 21/02

(54) **METHOD FOR MANUFACTURING SEMICONDUCTOR DEVICE**

(30) Priority: 27.11.2023 JP 2023199865
(71) Applicant: Tazmo Co., Ltd., Okayama-shi, Okayama 701-1221 (JP)
(72) Inventor: IKAGAWA, Yoshinori, Okayama-shi, Okayama 701-1221 (JP); FUWA, Yasuhiro, Kyoto-shi, Kyoto 612-8089 (JP)
(74) Representative: Knöner, Gregor
(86) International application number: PCT/JP2024/040137
(87) International publication number: WO 2025/115594

(57) **Abstract**

According to a method of manufacturing a semiconductor device, an N+ layer doped with N type impurity at a high concentration is formed in a base material by implanting the N type impurity from a side corresponding to a main surface of the base material (N+ layer forming step). The base material is a WBG semiconductor doped with the N type impurity at a low concentration. A dividing layer is formed in the base material at a predetermined position having a depth from the main surface greater than that of a forming region or a forming intended region of the N+ layer (dividing layer forming step). The dividing layer allows the base material to be divided at the predetermined position. Next, the main surface of the base material is held by a dummy substrate (first holding step). Then, the base material is divided at the predetermined position using the dividing layer to separate a part of the base material on the side of the main surface from the base material while the part is maintained held by the dummy substrate (dividing step). As a result, the separated part on the side of the main surface becomes a semiconductor substrate including the N+ layer.

## Description

### Technical Field

The present invention relates to a technique of manufacturing semiconductor devices.

### Background Art

One of existing techniques of manufacturing semiconductor devices is a technique including a process of thinning a semiconductor wafer (a wafer having a thickness of about 350 µm, for example) to a desired thickness (a thickness of equal to or less than 150 µm, for example) by grinding the semiconductor wafer.

Attention has been directed in recent years toward a wide bandgap (hereafter abbreviated as "WBG") semiconductor such as SiC as a semiconductor material allowing a semiconductor device to operate normally even at high temperature reaching 250°C or higher. The WBG semiconductor is also a semiconductor material allowing increase in switching speed, and in this regard, is expected to become a material of a semiconductor device for high-speed communication. The WBG semiconductor has a dielectric withstand voltage at least ten times higher than that of a conventional Si semiconductor device, so that it is a semiconductor material allowing thinning of an N-type layer (a drift layer) doped with N type impurity at a low concentration. For these reasons, the WBG semiconductor is a semiconductor material capable of having both characteristics of being low in resistance value (low ON resistance) and being high in withstand voltage, and in this regard, is expected to function as a material of a high-voltage semiconductor device. As described above, the WBG semiconductor has advantages in various aspects as a material of semiconductor devices.

### Citation List

### Patent Literature

Patent literature 1: Japanese published unexamined patent No. 2007-250576

### Summary of Invention

### Technical Problem

On the other hand, the WBG semiconductor is an expensive semiconductor material. Hence, if the semiconductor wafer is to be thinned by grinding like in the conventional case, a part of the semiconductor wafer removed by the grinding becomes waste, causing noticeable increase in material cost.

For manufacturing a high-voltage semiconductor device using the WBG semiconductor in the conventional case, an N- type semiconductor layer (an N- layer) is required to be formed by epitaxial growth. However, the epitaxial growth takes a long time. Moreover, as a withstand voltage required for the semiconductor device becomes higher, a thickness required for the N- layer becomes larger, requiring a longer time for the epitaxial growth. Hence, forming the N- layer by the epitaxial growth is one of causes for increasing running cost required for manufacturing the semiconductor device.

Thus, in relation to a technique of manufacturing a semiconductor device using a WBG semiconductor, the present invention is intended to reduce manufacturing cost significantly.

### Solution to Problem

A method of manufacturing a semiconductor device according to the present invention comprises an N+ layer forming step, a dividing layer forming step, a first holding step, and a dividing step (first aspect). In the N+ layer forming step, an N+ layer doped with N type impurity at a high concentration is formed in a base material by implanting the N type impurity from a side corresponding to a main surface of the base material. The base material is a WBG semiconductor doped with the N type impurity at a low concentration. In the dividing layer forming step, a dividing layer is formed in the base material at a predetermined position having a depth from the main surface greater than that of a forming region or a forming intended region of the N+ layer. The dividing layer allows the base material to be divided at the predetermined position. After the dividing layer forming step, the main surface of the base material is held by a dummy substrate in the first holding step. After the first holding step, in the dividing step, the base material is divided at the predetermined position using the dividing layer to separate a part of the base material on the side of the main surface from the base material while the part is maintained held by the dummy substrate. As a result, the separated part on the side of the main surface becomes a semiconductor substrate including the N+ layer.

According to the above manufacturing method, the semiconductor substrate thereby formed includes both the N+ layer and an N- layer (a semiconductor layer doped with the N type impurity at a low concentration). According to the above manufacturing method, by preparing the base material (an ingot or a semiconductor wafer cut out from the ingot) doped with the N type impurity at a concentration same as the concentration thereof in a part of the semiconductor substrate to become the N-layer, it becomes possible to form the desired semiconductor substrate including both the N+ layer and the N- layer only through the simple processes (processes implementable in a short time) of implanting the N type impurity further into the base material (formation of the N+ layer) and dividing the base material at the predetermined position. In other words, it is possible to shorten a time significantly required for manufacturing the semiconductor substrate compared to the conventional manufacturing method of forming the N- layer by epitaxial growth.

According to the above manufacturing method, the part on the side of the main surface with respect to the dividing layer (the part to become the semiconductor substrate) is held by the dummy substrate. Thus, even if the thickness of this part is small, it is still possible to facilitate handling in a subsequent stage. Thus, in the dividing layer forming step, when the predetermined position for forming the dividing layer is determined, it is possible to set the thickness of the part that is to be separated from the base material (the part to become the semiconductor substrate) to be as small as possible (for example, as small as possible within a thickness range responsive to a required withstand voltage) and thereby determine the predetermined position. In other words, it is possible to form the thin semiconductor substrate without performing the conventional process of scraping away the WBG semiconductor to the desired thickness by grinding. Thus, it is possible to reduce waste (waste occurring during the course of manufacture) of the WBG semiconductor, which is a precious material.

The manufacturing method according to the above first aspect may further comprise a device forming step, a second holding step, and a detaching step (second aspect). Particulars thereof are as follows. After the dividing step, in the device forming step, at least a part of an element is formed in the semiconductor substrate from a side corresponding to a surface of the semiconductor substrate opposite to the main surface. The element is to be provided to the semiconductor device. After the device forming step, in the second holding step, the surface of the semiconductor substrate is held by a holder different from the dummy substrate. After the second holding step, the dummy substrate is detached from the semiconductor substrate in the detaching step. In performing the steps from the N+ layer forming step to the detaching step repeatedly, the dummy substrate having been detached in the detaching step is reused as a dummy substrate to be used in the first holding step.

According to the above manufacturing method, the dummy substrate is preferably made of a WBG semiconductor of the same type as the semiconductor substrate to be held by the dummy substrate or a WBG semiconductor of a type having a similar thermal expansion coefficient to the semiconductor substrate (for example, such a WBG semiconductor having a heat resisting temperature of equal to or greater than 1800°C). Reason for this is that it can reduce a difference in thermal expansion coefficient between the dummy substrate and the semiconductor substrate and eventually, can reduce warpage that might be caused by the difference in thermal expansion coefficient during heating in a subsequent step. The above second aspect achieves reuse of the dummy substrate, so that the dummy substrate can effectively be used repeatedly without being wasted. Thus, such an expensive substrate made of a WBG semiconductor can be used as the dummy substrate.

In the manufacturing method according to the above second aspect, in the first holding step, a fixing part having a dotted pattern or a linear pattern for fixing the dummy substrate may be formed in a peripheral region of the main surface of the base material (third aspect).

According to the above third aspect, forming the fixing part into a dotted pattern or a linear pattern allows reduction in a fixing area to eventually allow the dummy substrate to be detached comparatively easily from the semiconductor substrate. Furthermore, forming the fixing part in the peripheral region makes it possible to reduce influence over the element of the semiconductor device that might be caused during detachment of the dummy substrate (influence by stress or heat to be generated during the detachment).

In the manufacturing method according to the above third aspect, the dummy substrate used in the first holding step may be a substrate including a joining preventive layer formed in a region inside a region that is to face the peripheral region of the main surface of the base material (fourth aspect).

According to the above fourth aspect, it is possible to prevent the dummy substrate from being joined to the inside region (the region to become the semiconductor device) of the main surface of the base material where the dummy substrate is not intended to be joined.

In the manufacturing method according to any one of the above first to third aspects, the dummy substrate used in the first holding step may be an annular substrate to hold a peripheral region of the main surface of the base material (fifth aspect).

The dummy substrate having an annular shape used in the above fifth aspect can be formed by using a disk-shape substrate and cutting out an inside part of the substrate. The cutout inside part is reusable as a dummy substrate in manufacturing another semiconductor substrate having a different size. Thus, it is possible to use the dummy substrate effectively.

The manufacturing method according to any one of the above first to fifth aspects may further comprise an electrode layer forming step that forms an electrode layer on the main surface of the base material after the N+ layer forming step and before the first holding step (sixth aspect).

According to the above sixth aspect, the electrode layer is formed before the first holding step. Thus, by heating the electrode layer locally through application of laser light in holding the main surface of the base material using the dummy substrate in the first holding step, a fixing part for fixing the dummy substrate to the main surface of the base material can be formed at a site of the laser light application.

### Advantageous Effects of Invention

According to the present invention, in relation to a technique of manufacturing a semiconductor device using a WBG semiconductor, it is possible to reduce manufacturing cost significantly.

### Brief Description of Drawings

FIG. 1 is a conceptual view showing partial processes of a manufacturing method according to an embodiment in order in which the processes are performed.
FIG. 2 is a conceptual view showing partial processes continued from FIG. 1 in order in which the processes are performed.
FIG. 3 is a conceptual view showing partial processes continued from FIG. 2 in order in which the processes are performed.
FIG. 4 is a conceptual view showing partial processes continued from FIG. 3 in order in which the processes are performed.
FIG. 5 is a conceptual view showing a process continued from FIG. 4.
FIG. 6 is a plan view showing the shape of a fixing part formed in the embodiment.
FIG. 7 is a conceptual view showing partial processes of a manufacturing method according to a first modification in order in which the processes are performed.
FIG. 8 is a conceptual view showing partial processes of a manufacturing method according to a second modification in order in which the processes are performed.
FIG. 9 is a conceptual view showing a first holding step performed in a third modification.
FIG. 10 is a conceptual view showing a first holding step performed in a fourth modification.
FIG. 11A is a conceptual view showing a partial step in a first holding step performed in a fifth modification, and FIGS. 11B and 11C are conceptual views showing two additional modifications of the partial step.

### Description of Embodiments

A method of manufacturing a semiconductor device according to the present invention will be described below in detail by providing an embodiment and modifications of the manufacturing method. The manufacturing method described below can be implemented using various types of known apparatuses.

### [1] Embodiment

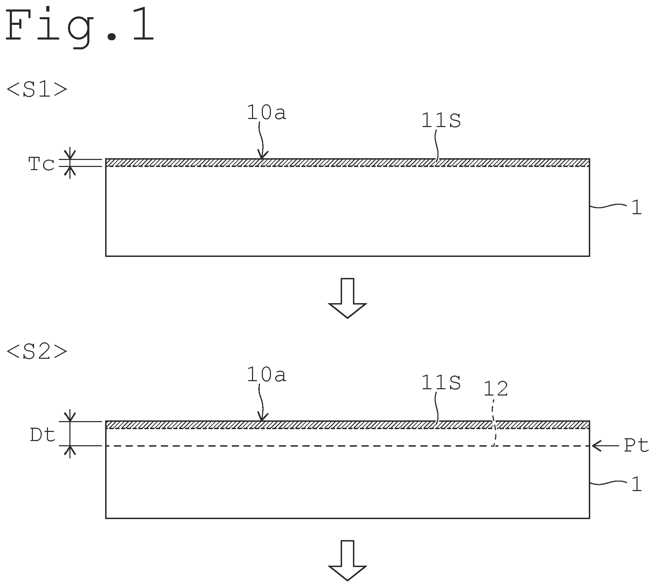

FIGS. 1 to 5 are conceptual views showing the manufacturing method according to the embodiment in order in which processes are performed. This manufacturing method includes an N+ layer forming step S1, a dividing layer forming step S2, a first holding step S3, a dividing step S4, a device forming step S5, a second holding step S6, a detaching step S7, an electrode layer forming step S8, a transferring step S9, and a singulating step S10 that are performed in this order. Each of the steps will be described below in detail.

### <N+ Layer Forming Step S1>

In the N+ layer forming step S1 (see FIG. 1), a base material 1 is prepared first that is a WBG semiconductor doped with N type impurity at a low concentration. Here, the "low concentration" means a case where the concentration of the N type impurity in the WBG semiconductor is equal to or less than 1 × 10¹⁷ cm⁻³. As the WBG semiconductor, semiconductor materials such as SiC, diamond, GaN, GaO, Ga₂O₃, AlN, BN, and GaAs are available. As the base material 1, a single-crystalline ingot made of the WBG semiconductor may be prepared, or a semiconductor wafer cut out from the ingot (a wafer having a thickness of about 350 µm, for example) may be prepared.

Then, an N+ layer 11S doped with the N type impurity at a high concentration is formed in the base material 1 by implanting the N type impurity from a side corresponding to a main surface 10a of the base material 1. Here, the "high concentration" means a case where the concentration of the N type impurity in the WBG semiconductor is equal to or greater than 1 × 10¹⁸ cm⁻³. A surface described next is used as the main surface 10a. If the base material 1 is an ingot, a flat cut surface exposed by cutting off an end part of the ingot or a surface prepared by polishing the cut surface is used as the main surface 10a. If the base material 1 is a semiconductor wafer, a flat cut surface resulting from cutting out the semiconductor wafer from an ingot or a surface prepared by polishing the cut surface is used as the main surface 10a.

In the present embodiment, the N+ layer 11S allows ohmic contact between an electrode layer 4 and a semiconductor substrate K when the electrode layer 4 is formed on the main surface 10a (a back surface Kb of the semiconductor substrate K) in the electrode layer forming step S8 described later. Such ohmic contact can be formed if a thickness Tc of the N+ layer 11S is about several micrometers.

### <Dividing Layer Forming step S2>

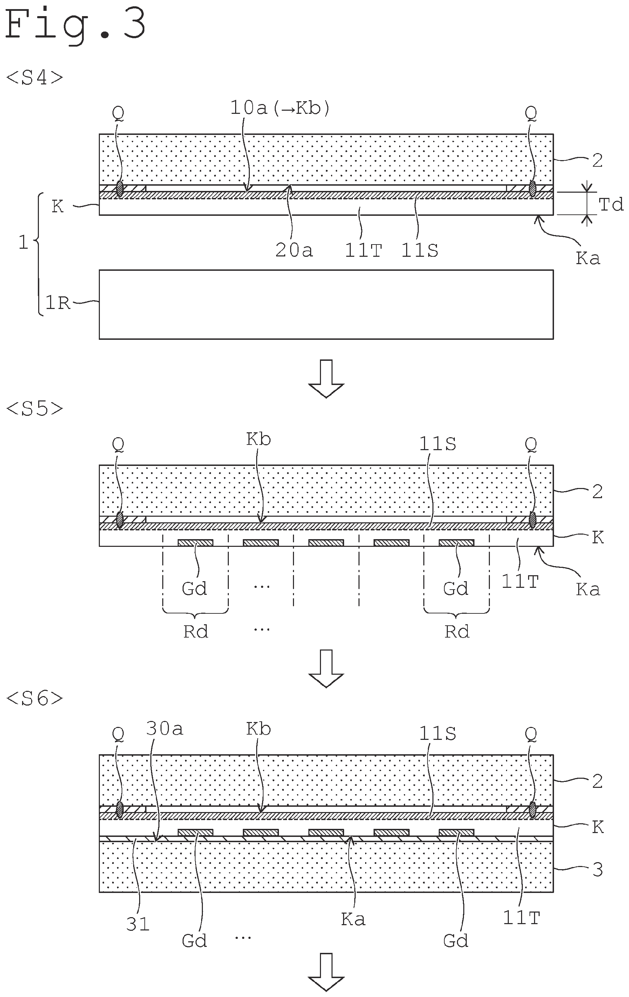

In the dividing layer forming step S2 (see FIG. 1), a dividing layer 12 is formed in the base material 1 at a predetermined position Pt (a position at a predetermined depth Dt) having a depth from the main surface 10a greater than that of a forming region of the N+ layer 11S. The dividing layer 12 allows the base material 1 to be divided at the predetermined position Pt. Here, the dividing layer 12 is a layer for allowing the semiconductor substrate K having a thickness Td corresponding to the predetermined depth Dt to be separated from the base material 1 (see the dividing step S4 in FIG. 3), and can be formed by implanting hydrogen ions from the side corresponding to the main surface 10a of the base material 1. The implantation of the hydrogen ions allows the dividing layer 12 to be formed at a position at a depth of about 10 µm from the main surface 10a or at a shallower position. As a result, it becomes possible to obtain the semiconductor substrate K having the thickness Td responsive to the depth of the dividing layer 12.

Instead of the method of implanting the hydrogen ions, the dividing layer 12 may be formed by a method of applying laser light from the side corresponding to the main surface 10a with a focus on the predetermined position Pt (the position at the predetermined depth Dt). This method allows the focus position to be changed in a depth direction, so that the dividing layer 12 can be formed at a position at a desired depth. Thus, the method of applying the laser light allows the dividing layer 12 to be formed at a deeper position (a position at a depth from about 50 to 150 µm from the main surface 10a, for example) than the method of implanting the hydrogen ions. As a result, it becomes possible to obtain the semiconductor substrate K having the thickness Td responsive to the depth of the dividing layer 12.

According to the described dividing layer forming step S2, unlike the conventional process of scraping away the WBG semiconductor by grinding to the desired thickness Td, the considerably thin semiconductor substrate K can be formed without wasting the semiconductor material (here, the expensive WBG semiconductor). On the other hand, such considerable thinness of the semiconductor substrate K makes it difficult for the semiconductor substrate K to maintain the flat shape by itself. In this regard, before the semiconductor substrate K is separated from the base material 1 in the dividing step S4 described later, measure should be taken to hold a part of the base material 1 to become the semiconductor substrate K using any type of holder and thereby allow the flat state of the semiconductor substrate K to be maintained using the holder even after the separation. Thus, the first holding step S3 described next is performed before the dividing step S4.

### <First Holding Step S3>

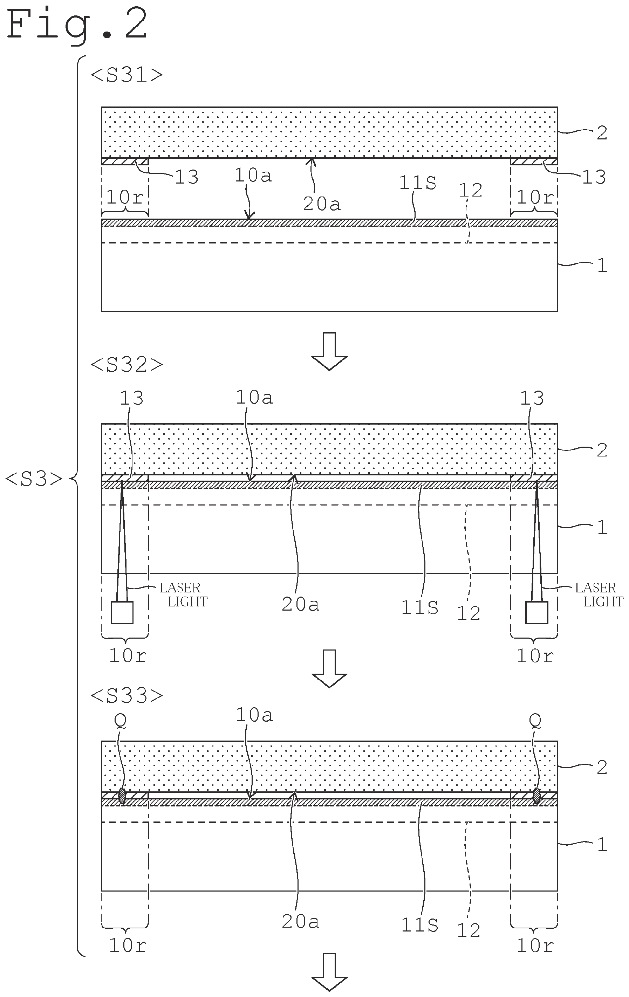

In the first holding step S3 (see FIG. 2), a dummy substrate 2 to be used as the above holder is prepared first.

Here, the dummy substrate 2 is simply required to have strength with which the flat state of the part of the base material 1 to become the semiconductor substrate K can be maintained even after the separation. For this reason, a substrate of inferior quality in electrical characteristic than the base material 1 can be used as the dummy substrate 2. On the other hand, the dummy substrate 2 is preferably made of a material having a similar thermal expansion coefficient to the base material 1. Reason for this is that it can reduce a difference in thermal expansion coefficient between the dummy substrate 2 and the semiconductor substrate K and eventually, can reduce warpage that might be caused by the difference in thermal expansion coefficient during heating in a subsequent step (such as the device forming step S5).

Thus, in the present embodiment, a polycrystalline semiconductor wafer made of a WBG semiconductor of the same type as the base material 1 or a WBG semiconductor of a type having a similar thermal expansion coefficient to the base material 1 (for example, such a WBG semiconductor having a heat resisting temperature of equal to or greater than 1800°C) is prepared as the dummy substrate 2.

By joining a holding surface 20a of the dummy substrate 2 to the main surface 10a of the base material 1, the part of the base material 1 to become the semiconductor substrate K becomes held by the dummy substrate 2.

More specifically, in preparing the dummy substrate 2, a metal layer 13 allowing joining between the base material 1 and the dummy substrate 2 is formed at a region of the holding surface 20a of the dummy substrate 2 over the entire perimeter where the holding surface 20a is to face a peripheral region 10r of the main surface 10a of the base material 1 in holding the main surface 10a, or is partially formed only at a place of the region where the joining is intended (step S31). Here, the metal layer 13 is a layer allowing the joining between the base material 1 and the dummy substrate 2 by being heated through application of laser light, and is a layer containing metal such as Cu, Al, Cr, Ti, Ta, or Au as a main component.

Next, the base material 1 and the dummy substrate 2 are superposed on each other to interpose the metal layer 13 between the peripheral region 10r of the main surface 10a and the holding surface 20a of the dummy substrate 2, and in this state, the metal layer 13 is heated through application of laser light (step S32). In doing this, to cause the base material 1 and the dummy substrate 2 to contact the metal layer 13 more tightly, the base material 1 and the dummy substrate 2 may be caught under pressure by quartz plates, for example.

By applying the laser light to the metal layer 13 as described above, a fixing part Q for fixing the dummy substrate 2 to the main surface 10a of the base material 1 can be formed at a site of the laser light application in the metal layer 13 (a site where the joining is intended) (step S33). More specifically, at the site of the laser light application, the metal layer 13 can be melted together with the base material 1 and the dummy substrate 2, or the metal as the main component of the metal layer 13 can be diffused into the base material 1 and the dummy substrate 2. As a result, a compound (such as metal silicide) or an alloy (such as an alloy of metal and Si) of the main component (such as WBG semiconductor) of each of the base material 1 and the dummy substrate 2 and the metal is formed as the fixing part Q at an interface between each of the base material 1 and the dummy substrate 2 and the metal layer 13, thereby joining the base material 1 (the part to become the semiconductor substrate K) and the dummy substrate 2 to each other through the fixing part Q.

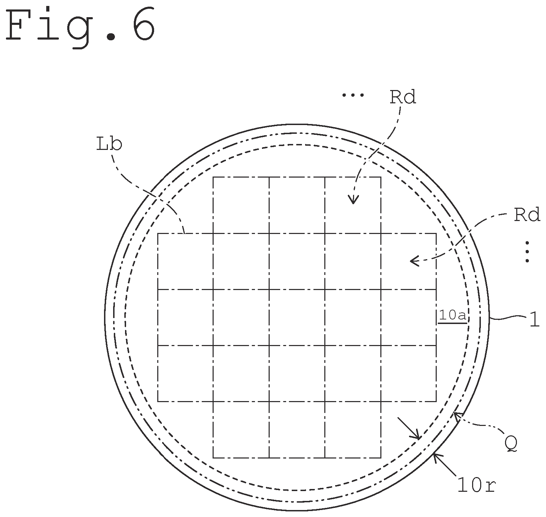

In the present embodiment, the fixing part Q is formed in the peripheral region 10r of the main surface 10a of the base material 1, and the dummy substrate 2 is joined to the main surface 10a of the base material 1 through the fixing part Q (step S33). In a subsequent step (such as the device forming step S5), a semiconductor device is formed in a region of the separated semiconductor substrate K inside the peripheral region 10r. More specifically, two or more device regions Rd for formation of semiconductor devices are set in the inside region (see FIG. 6). Thus, forming the fixing part Q in the peripheral region 10r makes it possible to reduce influence over the device region Rd (the semiconductor device) that might be caused during the detachment of the dummy substrate 2 from the semiconductor substrate K in the detaching step S7 described later (influence by stress or heat to be generated during the detachment).

Furthermore, in the present embodiment, the fixing part Q is formed into a linear pattern through scanning with laser light. Reason for this is that forming the fixing part Q into a linear pattern allows reduction in a fixing area to eventually allow the dummy substrate 2 to be detached comparatively easily from the semiconductor substrate K in the detaching step S7 described later. In the exemplary case shown in FIG. 6, the linear fixing part Q is formed at the peripheral region 10r over the entire perimeter and thereby formed in an annular shape.

From the viewpoint of facilitating the detachment, the fixing part Q may be formed in a dotted pattern by applying laser light to a pinpoint in the metal layer 13, and a plurality of such dotted fixing parts Q may be formed in order to allow the semiconductor substrate K to be held by the fixing parts Q. A method of forming the fixing part Q is not limited to the method using the metal layer 13 but may be changed, as appropriate, to a method of bringing the base material 1 and the dummy substrate 2 into direct surface contact with each other without using the metal layer 13 and applying laser light to an interface between the base material 1 and the dummy substrate 2 to form the fixing part Q.

As described above, by holding the part of the base material 1 to become the semiconductor substrate K using the dummy substrate 2, even if the thickness Td of the separated semiconductor substrate K is considerably small, it still becomes possible to maintain the flat state of the semiconductor substrate K using the dummy substrate 2 to allow the semiconductor substrate K to be handled easily in a subsequent stage. Thus, in the dividing layer forming step S2, when the predetermined position Pt for forming the dividing layer 12 is determined, it is possible to set the thickness Td (= the predetermined depth Dt) of the part that is to be separated from the base material 1 to be as small as possible (for example, as small as possible within a thickness range responsive to a required withstand voltage) and thereby determine the predetermined position Pt. In other words, it is possible to form the considerably thin semiconductor substrate K without performing the conventional process of scraping away the WBG semiconductor to the desired thickness Td by grinding. Thus, it is possible to reduce waste (waste occurring during the course of manufacture) of the WBG semiconductor, which is a precious material.

### <Dividing Step S4>

In the dividing step S4 (see FIG. 3), the base material 1 is divided at the predetermined position Pt (the position at the predetermined depth Dt) using the dividing layer 12, thereby separating a part of the base material 1 on the side of the main surface 10a (the part to become the semiconductor substrate K) from the base material 1 while the part is maintained held by the dummy substrate 2. By doing so, the semiconductor substrate K having the thickness Td corresponding to the predetermined depth Dt is formed. The semiconductor substrate K thereby formed includes both the N+ layer 11S and an N- layer 11T (a semiconductor layer doped with the N type impurity at a low concentration).

According to the above steps from the N+ layer forming step S1 to the dividing step S4, by preparing the base material 1 doped with the N type impurity at a concentration same as the concentration thereof in the part of the semiconductor substrate K to become the N- layer 11T, it becomes possible to form the desired semiconductor substrate K including both the N+ layer 11S and the N- layer 11T only through the simple processes (processes implementable in a short time) of implanting the N type impurity further into the base material 1 (formation of the N+ layer 11S) and dividing the base material 1 at the predetermined position Pt. In other words, it is possible to shorten a time significantly required for manufacturing the semiconductor substrate K compared to the conventional manufacturing method of forming the N-layer 11T by epitaxial growth.

The device forming step S5 described below is performed on the divided semiconductor substrate K. A residual part 1R of the base material 1 other than the semiconductor substrate K (a residual part left after the division) is reused for manufacture of a new semiconductor substrate K and a new semiconductor device.

### <Device Forming Step S5>

In the device forming step S5 (see FIG. 3), at least a part of an element Gd that is to be provided to the semiconductor device is formed in each of the device regions Rd (also see FIG. 6) set to the semiconductor substrate K. More specifically, in the semiconductor substrate K, the element Gd is formed in an area of the N- layer 11T from a side corresponding to a front surface Ka (a surface exposed by the division at the dividing layer 12 (a surface where the N- type WBG semiconductor is exposed)) of the semiconductor substrate K. While not particularly limited, an MOSFET, a Schottky diode or the like can be formed as the element Gd in each device region Rd.

In many cases, the described device forming step S5 is performed in a high temperature exceeding 1000°C. Here, if there is a large difference in thermal expansion coefficient between the semiconductor substrate K and the dummy substrate 2, warpage might be caused at the semiconductor substrate K resulting from the difference in thermal expansion coefficient when the semiconductor substrate K is heated to a high temperature. Such warpage becomes a cause for stress to be generated in the semiconductor substrate K, and such stress might be observed as a defect such as distortion at the semiconductor substrate K. Such stress might also become a cause for a defect to occur at the element Gd such as an MOSFET or a Schottky diode formed in the semiconductor substrate K.

On the other hand, in the present embodiment, the semiconductor wafer made of the WBG semiconductor of the same type as the base material 1 or a WBG semiconductor of a type having a similar thermal expansion coefficient to the base material 1 is used as the dummy substrate 2. This reduces a difference in thermal expansion coefficient between the dummy substrate 2 and the semiconductor substrate K. Thus, even if the semiconductor substrate K is heated to a high temperature together with the dummy substrate 2 in the device forming step S5, warpage is unlikely to occur at the semiconductor substrate K. For this reason, stress is unlikely to occur in the semiconductor substrate K, and thus a defect is also unlikely to occur at the element Gd formed in the semiconductor substrate K

### <Second Holding Step S6>

In the second holding step S6 (see FIG. 3), the front surface Ka of the semiconductor substrate K is held by a holder 3 different from the dummy substrate 2. The holder 3 to be used may be a substrate similar to the dummy substrate 2 or may be a substrate made of a different material (such as Si, sapphire, or quartz) not limited to semiconductor. If such a substrate is used as the holder 3, a holding surface 30a of the holder 3 is bonded to the front surface Ka of the semiconductor substrate K using an adhesive member 31 (such as heat-resistant double-sided tape).

The holder 3 to be used may be configured to allow the front surface Ka of the semiconductor substrate K to be chucked through vacuum suction. This holder 3 eliminates the need for the adhesive member 31, making it possible to prevent attachment of a foreign object to the front surface Ka of the semiconductor substrate K.

### <Detaching step S7>

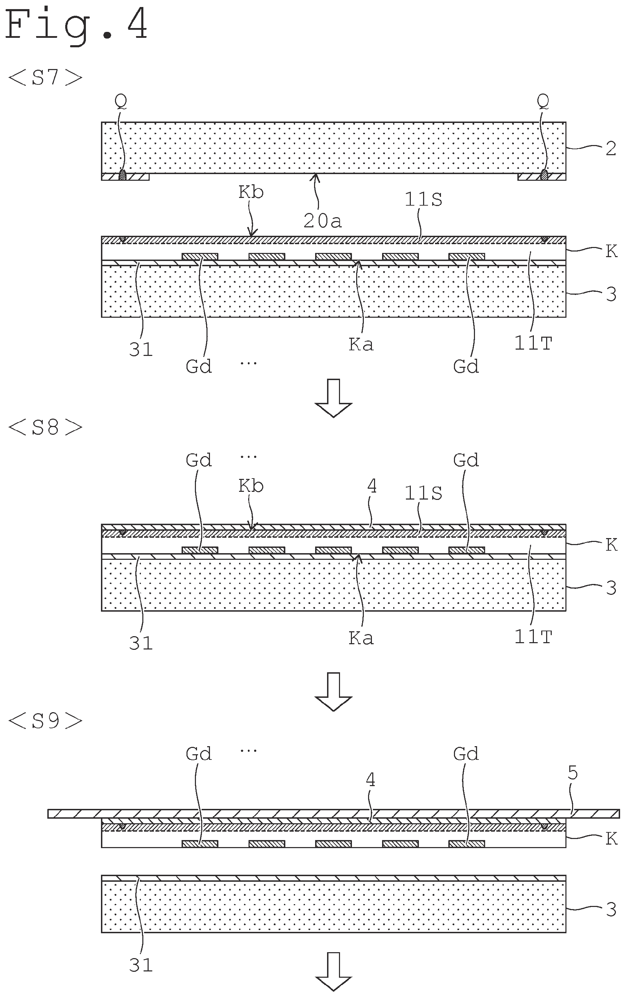

In the detaching step S7 (see FIG. 4), while the semiconductor substrate K is held by the holder 3, the dummy substrate 2 is detached from the semiconductor substrate K.

As a first specific example, a wedge is driven into between the semiconductor substrate K and the dummy substrate 2 to break the fixing part Q, thereby allowing the dummy substrate 2 to be detached from the semiconductor substrate K. As a second specific example, laser light is applied to the fixing part Q to break the fixing part Q, thereby allowing the dummy substrate 2 to be detached from the semiconductor substrate K.

As a third specific example, the dummy substrate 2 may be detached from the semiconductor substrate K by applying laser light to the semiconductor substrate K to cut the semiconductor substrate K into an annular shape at a position inside the fixing part Q. As a fourth specific example, the dummy substrate 2 may be detached from the semiconductor substrate K by tearing the semiconductor substrate K and the dummy substrate 2 vertically from each other using binding force of the fixing part Q to fracture the semiconductor substrate K into an annular shape at a position inside the fixing part Q.

In the present embodiment, after the dummy substrate 2 is detached from the semiconductor substrate K, the detached dummy substrate 2 is reused. More specifically, after being detached from the semiconductor substrate K, the holding surface 20a of the dummy substrate 2 is polished to remove residues of the fixing part Q and the semiconductor substrate K from the holding surface 20a. Then, in performing the steps from the N+ layer forming step S1 repeatedly, the dummy substrate 2 is reused in the first holding step S3.

In the present embodiment, the expensive dummy substrate 2 made of the WBG semiconductor is used. Meanwhile, as the dummy substrate 2 is reusable as described above, the expensive dummy substrate 2 can effectively be used repeatedly without being wasted.

### <Electrode Layer Forming Step S8>

In the electrode layer forming step S8 (see FIG. 4), the electrode layer 4 is formed on the back surface Kb of the semiconductor substrate K having been exposed by the detachment of the dummy substrate 2. As an example, a sputtering method may be used for forming the electrode layer 4. At this time, as the N+ layer 11S is exposed on the back surface Kb of the semiconductor substrate K, the electrode layer 4 can be formed by ohmic contact on the back surface Kb.

### <Transferring Step S9>

In the transferring step S9 (see FIG. 4), the semiconductor substrate K is transferred from the holder 3 to a holding sheet 5 (such as dicing tape). More specifically, the semiconductor substrate K is held by the holding sheet 5 from a side corresponding to the back surface Kb, and then the holder 3 is detached from the semiconductor substrate K.

In the present embodiment, after the holder 3 is detached from the semiconductor substrate K, the detached holder 3 is reused in the second holding step S6 in performing the steps from the N+ layer forming step S1 repeatedly.

### <Singulating Step S10>

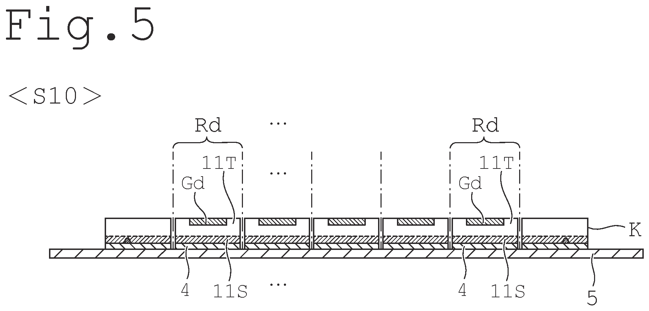

In the singulating step S10 (see FIG. 5), while the semiconductor substrate K is maintained held by the holding sheet 5, the semiconductor substrate K is subjected to cutting to individually singulate the device regions Rd set to the semiconductor substrate K. More specifically, the semiconductor substrate K is cut along boundary lines Lb (see FIG. 6) for partitioning the device regions Rd to singulate the device regions Rd individually. As a method of this cutting, a method such as a blade dicing method, a plasma etching method, or a laser ablation method may be used. This results in manufacture of a plurality of semiconductor devices each including the element Gd such as an MOSFET or a Schottky diode.

Compared to the conventional manufacturing method of forming the N- layer 11T by epitaxial growth, the manufacturing method of the present embodiment makes it possible to shorten a time significantly required for manufacturing the semiconductor substrate K, as described above. The thin semiconductor substrate K can be formed without performing the conventional process of scraping away the WBG semiconductor by grinding to the desired thickness Td. Thus, it is possible to reduce waste (waste occurring during the course of manufacture) of the WBG semiconductor, which is a precious material. As a result, in relation to the technique of manufacturing the semiconductor device using the WBG semiconductor, it is possible to reduce manufacturing cost significantly.

### [2] Modifications

### [2-1] First Modification

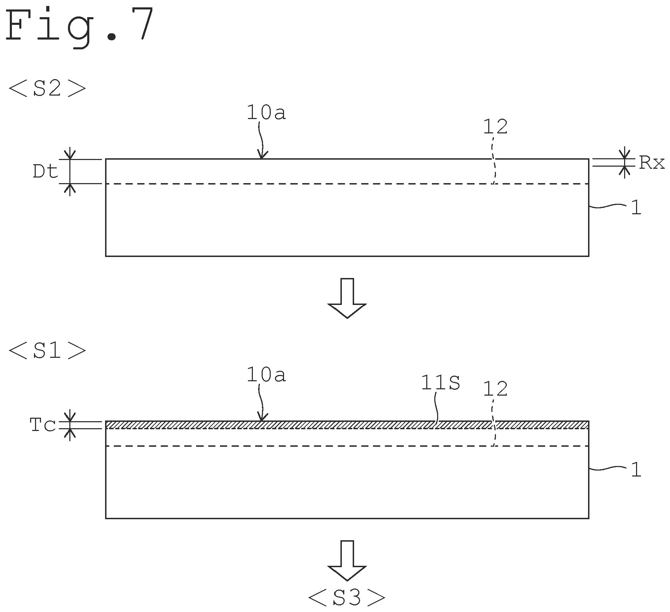

FIG. 7 is a conceptual view showing partial processes of a manufacturing method according to a first modification in order in which the processes are performed. In the above manufacturing method, the dividing layer forming step S2 may be performed before the N+ layer forming step S1. In this case, in the dividing layer forming step S2, the base material 1 is prepared that is a WBG semiconductor doped with N type impurity at a low concentration. Next, in the dividing layer forming step S2, the predetermined position Pt (the position at the predetermined depth Dt) is set to have a depth from the main surface 10a greater than that of a forming intended region Rx of the N+ layer 11S, and then the dividing layer 12 is formed at the predetermined position Pt. Then, in the N+ layer forming step S1, the N type impurity is implanted from a side corresponding to the main surface 10a of the base material 1. As a result, the N+ layer 11S doped with the N type impurity at a high concentration is formed in the forming intended region Rx.

### [2-1] Second Modification

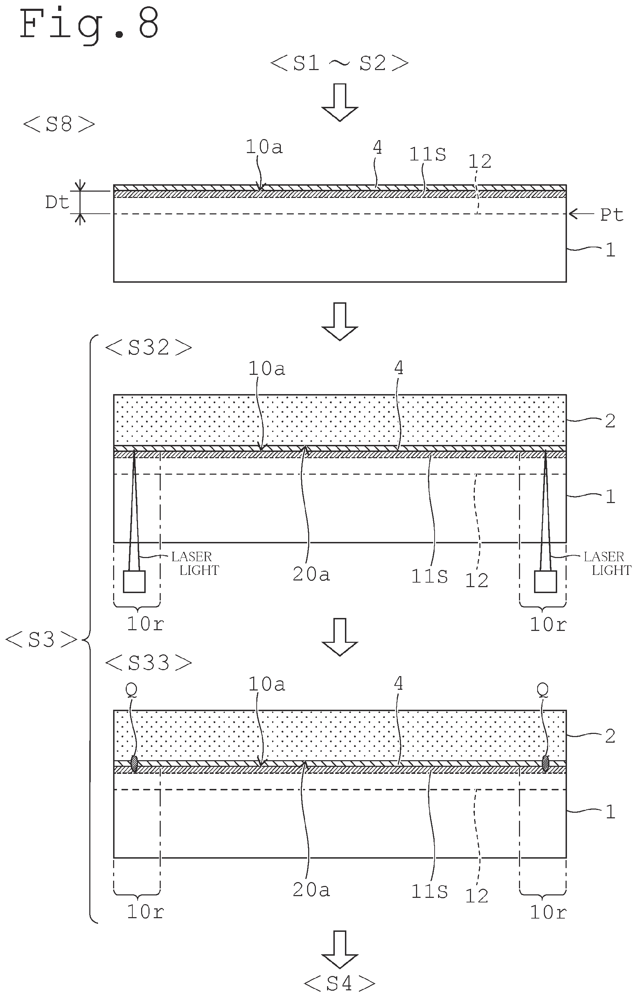

FIG. 8 is a conceptual view showing partial processes of a manufacturing method according to a second modification in order in which the processes are performed. In the above manufacturing method, the electrode layer forming step S8 may be performed after the N+ layer forming step S1 and before the first holding step S3. More specifically, the electrode layer 4 is formed on the main surface 10a of the base material 1 (a surface to become the back surface Kb of the semiconductor substrate K). In this case, as the N+ layer 11S is also exposed on the main surface 10a of the base material 1, the electrode layer 4 can be formed on the main surface 10a through ohmic contact.

According to the second modification, by forming the electrode layer 4 before the first holding step S3, the electrode layer 4 becomes available as the metal layer 13 in the first holding step S3. In other words, the fixing part Q can be formed using the electrode layer 4. More specifically, the dummy substrate 2 is superposed on the electrode layer 4 to interpose the electrode layer 4 between the main surface 10a of the base material 1 and the holding surface 20a of the dummy substrate 2 (step S32). In this state, laser light is applied to heat the electrode layer 4 locally, thereby allowing the fixing part Q to be formed using the electrode layer 4 (step S33). At this time, by applying the laser light to a part of the electrode layer 4 on the peripheral region 10r of the main surface 10a, it becomes possible to form the fixing part Q in the peripheral region 10r where influence over the device region Rd can be reduced (step S33).

If different materials are required to be used for forming the electrode layer 4 and the metal layer 13, both the electrode layer 4 and the metal layer 13 may be formed in the electrode layer forming step S8, and in the first holding step S3, the fixing part Q may be formed using the metal layer 13.

### [2-3] Third Modification

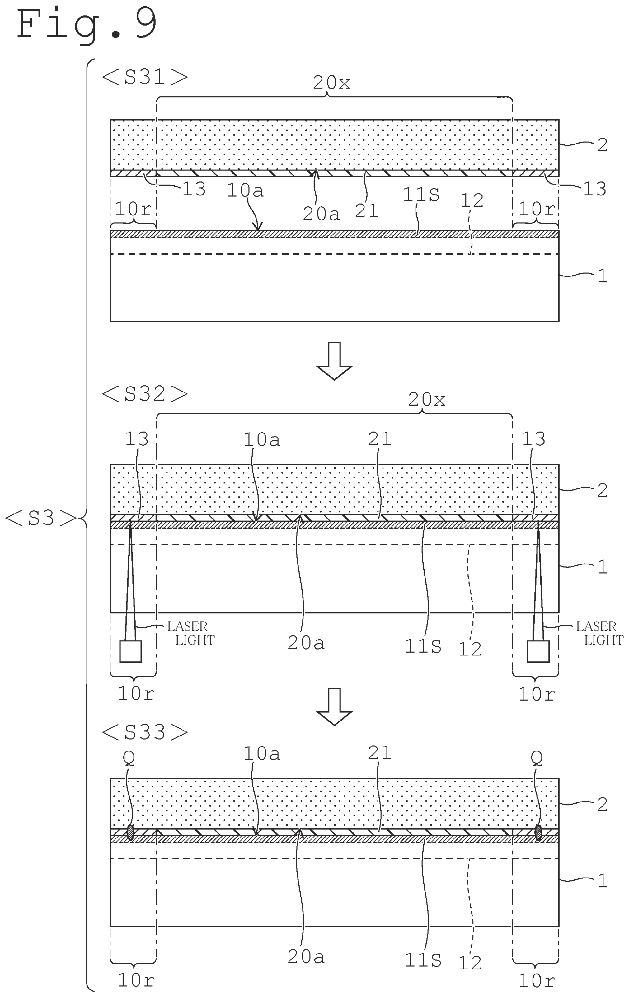

FIG. 9 is a conceptual view showing the first holding step S3 performed in a third modification. In the above manufacturing method, the dummy substrate 2 used in the first holding step S3 may be a substrate including a joining preventive layer 21 for preventing joining between the dummy substrate 2 and the base material 1 (the semiconductor substrate K) formed in a region as follows. This region is a region 20x of the holding surface 20a of the dummy substrate 2 inside a region (a forming region of the metal layer 13) that is to face the peripheral region 10r of the main surface 10a of the base material 1. While not particularly limited, the joining preventive layer 21 is an SiO₂ layer or a carbon (C) layer, for example. The SiO₂ layer is formed by growing SiO₂ by an LOCOS method on the holding surface 20a of the dummy substrate 2. The carbon layer is formed by depositing carbon by a sputtering method or a CVD method on the holding surface 20a of the dummy substrate 2.

According to the third modification, it is possible to prevent the dummy substrate 2 from being joined to the inside region (the region to become the semiconductor device) of the main surface 10a of the base material 1 where the dummy substrate 2 is not intended to be joined. Furthermore, by forming the joining preventive layer 21 to the same height as the metal layer 13, a clearance between the dummy substrate 2 and the base material 1 can be filled with the joining preventive layer 21 in the region inside the forming region of the metal layer 13. As a result, it is possible to prevent distortion (distortion resulting from the clearance) that might occur at the semiconductor substrate K to be formed subsequently.

### [2-4] Fourth Modification

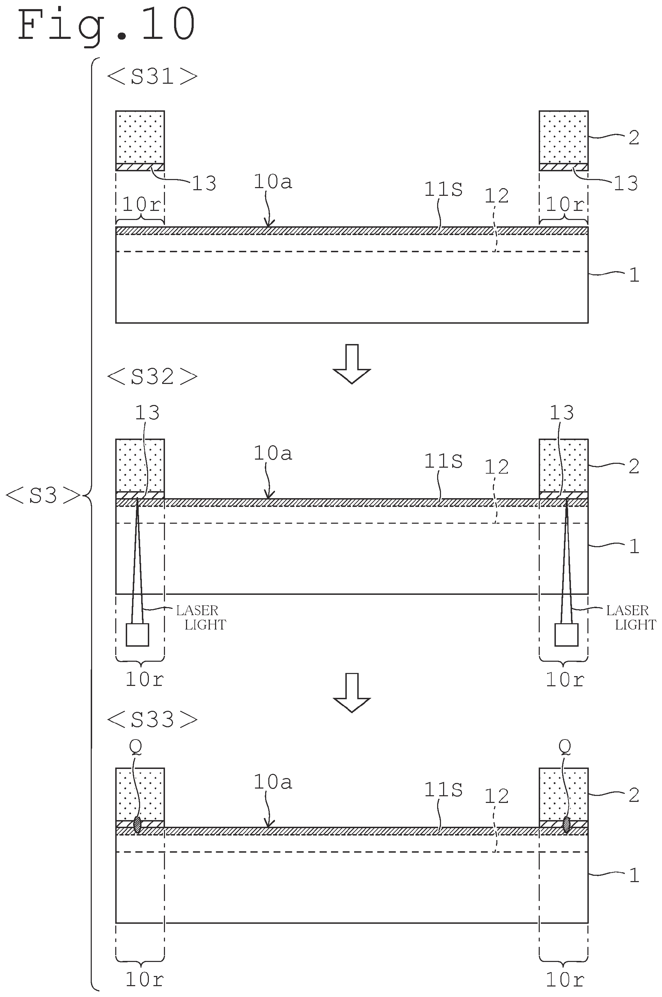

FIG. 10 is a conceptual view showing the first holding step S3 performed in a fourth modification. In the above manufacturing method, a substrate having an annular shape for holding the peripheral region 10r of the main surface 10a of the base material 1 may be used as the dummy substrate 2 in the first holding step S3.

The dummy substrate 2 having such an annular shape can be formed by using a disk-shape substrate and cutting out an inside part of the substrate. The cutout inside part is reusable as another dummy substrate 2 in manufacturing another semiconductor substrate K having a different size. Thus, the fourth modification achieves effective use of the dummy substrate 2.

### [2-5] Fifth Modification

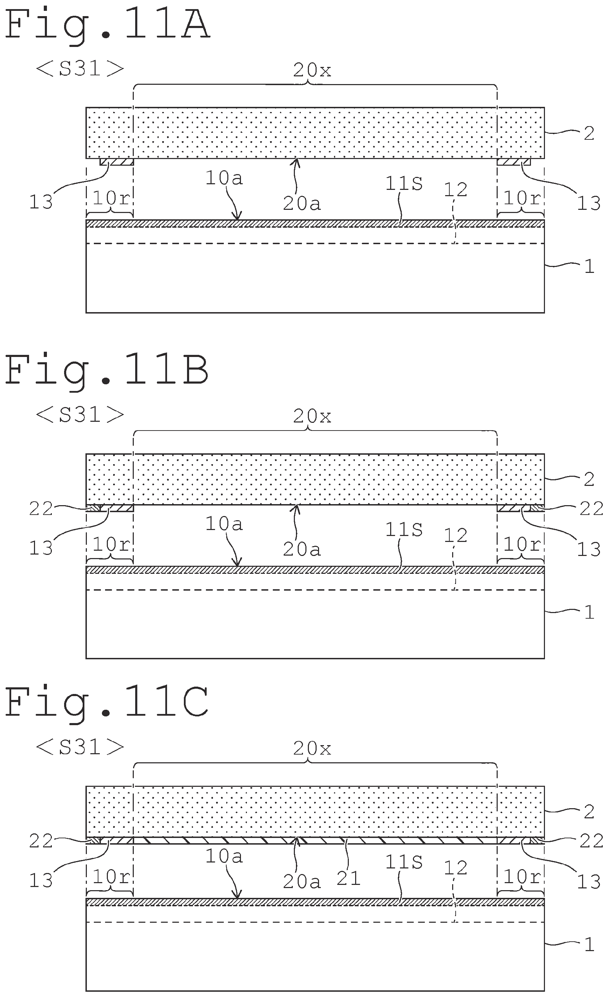

FIG. 11A is a conceptual view showing the step S31 of the first holding step S3 performed in a fifth modification. As shown in this drawing, the metal layer 13 may be formed in a region of the holding surface 20a of the dummy substrate 2 shifted internally from an outer peripheral edge of the holding surface 20a. With this configuration, even if the metal layer 13 is deformed by heat or the like in a subsequent step, the metal layer 13 is unlikely to leak to the outside.

FIGS. 11B and 11C are conceptual views showing two additional modifications of the step S31 shown in FIG. 11A. As shown in these drawings, from the viewpoint of preventing leakage of the metal layer 13 to the outside, the holding surface 20a of the dummy substrate 2 may be provided with a leakage preventive layer 22 formed between the outer peripheral edge of the holding surface 20a and the forming region of the metal layer 13. Here, the leakage preventive layer 22 is an SiO₂ layer or a carbon (C) layer, for example. The SiO₂ layer is formed by growing SiO₂ by an LOCOS method on the holding surface 20a of the dummy substrate 2. The carbon layer is formed by depositing carbon by a sputtering method or a CVD method on the holding surface 20a of the dummy substrate 2. The leakage preventive layer 22 may be formed on the holding surface 20a of the dummy substrate 2 together with the joining preventive layer 21 (see FIG. 11C).

### [2-6] Sixth Modification

According to a sixth modification, the method of manufacturing the semiconductor device may include the device forming step S5, the second holding step S6, and the detaching step S7 of the above steps, and this manufacturing method may be implemented after the steps from the N+ layer forming step S1 to the dividing step S4 are performed.

### [2-7] Seventh Modification

According to a seventh modification, the method of manufacturing the semiconductor device may include the N+ layer forming step S1, the dividing layer forming step S2, the first holding step S3, and the dividing step S4 of the above steps, and the steps from the device forming step S5 to the detaching step S7 may be performed after implementation of this manufacturing method.

The above explanations of the embodiments and the modifications are nothing more than illustrative in any respect, nor should be thought of as restrictive. The scope of the present invention is indicated by claims rather than the above embodiments and modifications. Furthermore, it is intended that all changes that are equivalent to a claim in the sense and realm of the doctrine of equivalence be included within the scope of the present invention.

Some of the steps constituting the method of manufacturing the semiconductor device may be extracted partially as a subject of the invention or each of the steps may be extracted individually as a subject of the invention from the above embodiments and modifications.

### Reference Signs List

1 Base material
1R Residual part
2 Dummy substrate
3 Holder
4 Electrode layer
5 Holding sheet
K Semiconductor substrate
Q Fixing part
10a Main surface
10r Peripheral region
11S N+ layer
11T N- layer
12 Dividing layer
13 Metal layer
20a Holding surface
20x Inside region
21 Joining preventive layer
22 Leakage preventive layer
30a Holding surface
31 Adhesive member
Dt Predetermined depth
Gd Element
Ka Front surface
Kb Back surface
Lb Boundary line
Pt Predetermined position
Rd Device region
Rx Forming intended region
Tc, Td Thickness
S1 N+ layer forming step
S2 Dividing layer forming step
S3 First holding step
S4 Dividing step
S5 Device forming step
S6 Second holding step
S7 Detaching step
S8 Electrode layer forming step
S9 Transferring step
S10 Singulating step

## Claims

1. A method of manufacturing a semiconductor device comprising:
an N+ layer forming step that forms an N+ layer doped with N type impurity at a high concentration in a base material by implanting the N type impurity from a side corresponding to a main surface of the base material, the base material being a WBG semiconductor doped with the N type impurity at a low concentration;
a dividing layer forming step that forms a dividing layer in the base material at a predetermined position having a depth from the main surface greater than that of a forming region or a forming intended region of the N+ layer, the dividing layer allowing the base material to be divided at the predetermined position;
a first holding step that holds the main surface of the base material using a dummy substrate after the dividing layer forming step; and
a dividing step that divides the base material at the predetermined position using the dividing layer, after the first holding step, to separate a part of the base material on the side of the main surface from the base material while the part is maintained held by the dummy substrate, thereby causing the part to become a semiconductor substrate including the N+ layer.

2. The method of manufacturing the semiconductor device according to claim 1, further comprising:
a device forming step that forms at least a part of an element in the semiconductor substrate from a side corresponding to a surface of the semiconductor substrate opposite to the main surface after the dividing step, the element being to be provided to the semiconductor device;
a second holding step that holds the surface of the semiconductor substrate using a holder different from the dummy substrate after the device forming step; and
a detaching step that detaches the dummy substrate from the semiconductor substrate after the second holding step, wherein
in performing the steps from the N+ layer forming step to the detaching step repeatedly, the dummy substrate having been detached in the detaching step is reused as a dummy substrate to be used in the first holding step.

3. The method of manufacturing the semiconductor device according to claim 2, wherein
in the first holding step, a fixing part having a dotted pattern or a linear pattern for fixing the dummy substrate is formed in a peripheral region of the main surface.

4. The method of manufacturing the semiconductor device according to claim 3, wherein
the dummy substrate used in the first holding step is a substrate including a joining preventive layer formed in a region inside a region that is to face the peripheral region of the main surface.

5. The method of manufacturing the semiconductor device according to any one of claims 1 to 3, wherein
the dummy substrate used in the first holding step is an annular substrate to hold a peripheral region of the main surface.

6. The method of manufacturing the semiconductor device according to any one of claims 1 to 5, further comprising:
an electrode layer forming step that forms an electrode layer on the main surface after the N+ layer forming step and before the first holding step.
